# EUROPEAN PATENT APPLICATION

(11) **EP 1 879 431 A1**
(43) Date of publication of application: **16.01.2008**
(21) Application number: 06730224.0
(22) Date of filing: 28.03.2006
(51) Int. Cl.: H05B 33/10

(54) **APPARATUS FOR FILM FORMATION AND METHOD FOR FILM FORMATION**

(30) Priority: 07.04.2005 JP 2005110760
(71) Applicant: TOHOKU UNIVERSITY, Aoba-ku Sendai-shi, Miyagi 980-8577 (JP); TOKYO ELECTRON LIMITED, Minato-ku Tokyo 107-8481 (JP); KABUSHIKI KAISHA TOYOTA JIDOSHOKKI, Kariya-shi, Aichi 448-8671 (JP)
(72) Inventor: OHMI, Tadahiro, Tohoku University, Sendai-shi, Miyagi 980-8577 (JP); MATSUOKA, Takaaki, TOKYO ELECTRON LIMITED, Tokyo 107-8481 (JP); NAKAYAMA, Shozo, KABUSHIKI K. TOYOTA JIDOSHOKKI, Kariya-shi Aichi 448-8671 (JP); ITO, Hironori, KABUSHIKI KAISHA TOYOTA JIDOSHOKKI, Kariya-shi Aichi 448-8671 (JP)
(74) Representative: Glawe, Delfs, Moll
(86) International application number: PCT/JP2006/306276
(87) International publication number: WO 2006/109562

(57) **Abstract**

In an apparatus for film formation, constituted so that an organic EL molecular gas is ejected into an ejection vessel, a plurality of organic EL material vessels are provided together with a piping system for connecting the plurality of organic EL material vessels to the ejection vessel. The plurality of organic EL material vessels are selectively put into a supply state of organic EL molecules. The piping system is constructed so that the carrier gas is fed into each organic EL material vessel in such a manner that the pressure during film formation and the pressure during non-film formation are equal to each other. During non-film formation, the carrier gas is allowed to flow from one of the organic EL material vessels to other material vessel.

## Description

### Technical Field

This invention relates to a film forming apparatus and a film forming method for forming a layer of a predetermined material and, in particular, relates to a film forming apparatus and a film forming method for forming a layer of a predetermined material by evaporating a raw material of the predetermined material.

### Background Art

A method of forming a layer of a predetermined material by evaporating a raw material of a predetermined material is widely used in the manufacture of semiconductor devices, flat panel display devices, and other electronic devices. Description will be restricted hereinbelow to an organic EL display device as one example of those electronic devices. If such an organic EL display device could have a sufficient brightness and a long lifetime, such as several tens of thousands of hours or more, the organic EL display device could implement an ideal flat panel display because the organic EL display device uses organic EL elements of a self-luminosity type and can realize a thin structure due to a reduction of peripheral components, such as backlight elements or devices. Requirements are imposed on the organic EL elements of the organic EL display device in view of characteristics as a display device and are such that lifetimes of the elements are long in spite of a large screen, no variation in luminous brightness appears in the screen and in the element lifetimes, and no defect, such as, typically, a dark spot appears. In order to satisfy such requirements, formation of an organic EL layer is quite important.

As a film forming apparatus for uniformly forming an organic EL layer on a large substrate, use is made of an apparatus described in Patent Document 1 or the like. The film forming apparatus of Patent Document 1 aims to achieve uniformity in film thickness on a large substrate by optimally arranging, in a tree fashion, a piping structure inside an injector disposed in the apparatus.

Currently, an organic EL layer is formed by a vacuum deposition apparatus kept in an atmosphere of 10⁻⁶Torr to 10⁻⁷ Torr or less. According to experiments by the present inventors, it has been found out that, in the current vacuum deposition apparatus, an organic EL layer is subjected to extensive contamination by organic compounds in an organic EL layer forming process and, as a result of this, the brightness and lifetime of organic EL light-emitting diodes (OLED) are largely reduced.

Further, in a continuous vacuum deposition apparatus having a load lock chamber, the case where an NPD layer, an Alq3 layer, and an MgAg electrode layer are formed immediately after a glass substrate is transferred into the load lock chamber kept in a vacuum of about 1×10⁻⁷ Torr is compared with the case where a substrate is left unchanged in an atmosphere of about 1×10⁻⁷ Torr for 30 minutes during forming each layer. In this event, it has been found out that, when samples that are exposed as the latter, to the atmosphere of about 1×10⁻⁷ Torr for 30 minutes during forming each layer, the brightness of such samples is reduced to about 1/3 and the lifetime taken until the brightness is degraded to half is reduced to 1/3 or less.

Zealous studies have been conducted about the foregoing lifetime degradation. As a result, the present inventors have found out that organic compounds, which become contamination sources, have high partial pressures in the vacuum state and, simultaneously, mean free paths of molecules of organic compounds become very long and, in consequence, contamination by organic compounds on the surface of a substrate become extremely polluted and results in a reduction of the lifetimes of the organic EL elements.

Further, it has been also found out that, in order to reduce variation in luminous brightness in a screen and element lifetime, film properties and film thickness at the time of organic EL element film formation should be uniform, which is quite important. The apparatus described in Patent Document 1 is given as an example of a film forming apparatus for uniformly depositing an organic EL thin film. Although the film thickness of an organic EL element formed by the apparatus of the above-mentioned structure is uniform, dark spots or variation in element lifetime undesirably takes place.

Further, as regards the injector described in Patent Document 1, no disclosure is made about the material and temperature of the injector. This shows that, depending on the conditions, there might raise a problem such that an organic EL material is deposited inside the injector and an organic EL material is decomposed inside the injector and thus decomposed products are deposited on a substrate, and, as a result, such organic EL elements do not act as desirable organic EL elements.

Further, in the conventional film forming method, an evaporated raw material is scattered omindirectionally so as to be deposited on portions other than a substrate and is thus vainly wasted and, further, since evaporation continues for a while even if heating of an evaporating dish is stopped, there is much waste of the raw material during non-film-formation. In order to reduce these wastes, the present inventors have previously proposed a film forming apparatus and a film forming method in that a raw material is conducted by using a carrier gas from a raw material container disposed in a reduced-pressure vessel to the surface of a substrate, in International Publication No. 2005/093120 pamphlet (Patent Document 2).

Patent Document 1: Japanese Unexamined Patent Application
Publication (JP-A) No. 2004-79904
Patent Document 2: International Publication No. 2005/093120 pamphlet

### Disclosure of the Invention

### Problem to be Solved by the Invention

In the film forming apparatus and the film forming method proposed in Patent Document 2, since it is possible to suppress generation of organic contaminants and material-decomposed/dissociated matters that adversely affect the properties of a film forming material, a high-quality thin film can be deposited. Therefore, when such a film forming apparatus and film forming method are applied to formation of an organic EL device, it is possible to obtain a high-quality organic EL device with a high brightness and a long lifetime.

On the other hand, according to Patent Document 2, when a substrate to be subjected to film formation has a large area, it is difficult to uniformly provide the film thickness and so on over the whole area of the substrate. Further, it is difficult to increase the film formation rate to thereby perform film formation efficiently. Further, it is proposed to change the temperature, flow rate, and pressure of gases such as an organic EL raw material and a carrier gas on shifting from the start of film formation to a film forming process and on shifting from the film forming process to stopping of the film formation. However, no proposal has been offered at all about quickly and smoothly switching an atmosphere according to the process, that is, about means for quickly performing a state transition. Therefore, it is difficult to form an organic EL thin film at high rate.

It is an object of this invention to provide a film forming apparatus and a film forming method that can achieve uniform film formation even in the case of a large-area substrate.

Further, it is an object of this invention to provide a film forming apparatus and a film forming method that can increase the film formation rate to thereby perform film formation efficiently.

Further, it is an object of this invention to provide a film forming apparatus and a film forming method that can quickly perform a state transition and, as a result of this, can form a high-quality film at high rate.

It is another object of this invention to provide a film forming apparatus and a film forming method that can continuously deposit a plurality of organic EL raw materials.

It is still another object of this invention to provide a film forming apparatus and a film forming method that can simultaneously form a film made of a plurality of components.

It is another object of this invention to provide a film forming apparatus having a structure in which an ejection vessel for ejecting a raw material gas and a carrier gas onto a substrate and a raw material container are connected by a piping system.

It is an object of this invention to provide a film forming apparatus that can quickly perform a process transition by improving a piping system of the film forming apparatus having the piping system.

### Means for Solving the Problem

According to a first aspect of this invention, there is obtained a film forming apparatus or a film forming method that evaporates a raw material for use in forming a film of a predetermined material and transports the raw material gas, evaporated, using a carrier gas, thereby depositing the film of the predetermined material on a substrate, wherein the carrier gas is caused to flow into evaporation means so as to make a gas phase pressure in the evaporation means equal to that during film formation, at at least one of the time before the film formation and the time of stopping the film formation. The gas that flows in the evaporation means to transport the evaporated raw material is discharged to the outside of the evaporation means. The discharged gas may be sent to, for example, a recovery system or may be sent to another evaporation means separately provided. In this case, there are provided a plurality of raw material containers each forming evaporation means and the raw material gas is transported by the carrier gas from one container to another raw material container during non-film-formation.

During the film formation, the carrier gas and the raw material gas are ejected by an ejection vessel. By this, the pressures and temperatures of the plurality of raw material containers are kept equal during the non-film-formation and the film formation.

A gas pressure control portion having an orifice is provided in a piping system between the evaporation means and the ejection vessel, thereby supplying the carrier gas containing the evaporated raw material to the ejection vessel at a predetermined flow rate and flow velocity. The gas sent from the gas pressure control portion is ejected into the ejection vessel from a plurality of supply ports provided in the ejection vessel. Therefore, it becomes possible to carry out film formation uniformly and at high rate even in the case of a large-area substrate.

### Effect of the Invention

Further, according to this invention, by providing the plurality of raw material containers and by selectively setting these raw material containers to an organic EL molecule supply state and quickly and smoothly carrying out a transition between the film formation and the non-film-formation, it is possible to minimize remaining and deposition of molecules of organic compounds and so on. By this, it is possible to form a high-quality, long-lifetime organic EL film.

### Brief Description of the Drawings

[Fig. 1] A schematic structural view showing a film forming apparatus according to one embodiment of this invention.
[Fig. 2] A diagram for explaining a state of the film forming apparatus shown in Fig. 1 before the start of film formation.
[Fig. 3] A diagram for explaining a state of the film forming apparatus shown in Fig. 1 during the film formation.
[Fig. 4] A diagram for explaining a state of the film forming apparatus shown in Fig. 1 at the time of stopping the film formation.
[Fig. 5] A schematic diagram for explaining a film forming apparatus according to another embodiment of this invention.
[Fig. 6] A schematic diagram for explaining a film forming apparatus according to still another embodiment of this invention.

### Description of Symbols

- V: valve
- MFC: mass flow controller
- 11, 12: raw material container
- 15: ejection vessel
- 151: organic compound molecule ejection apparatus
- 152: gas dispersion plate
- 153: filter

### Best Mode for Carrying Out the Invention

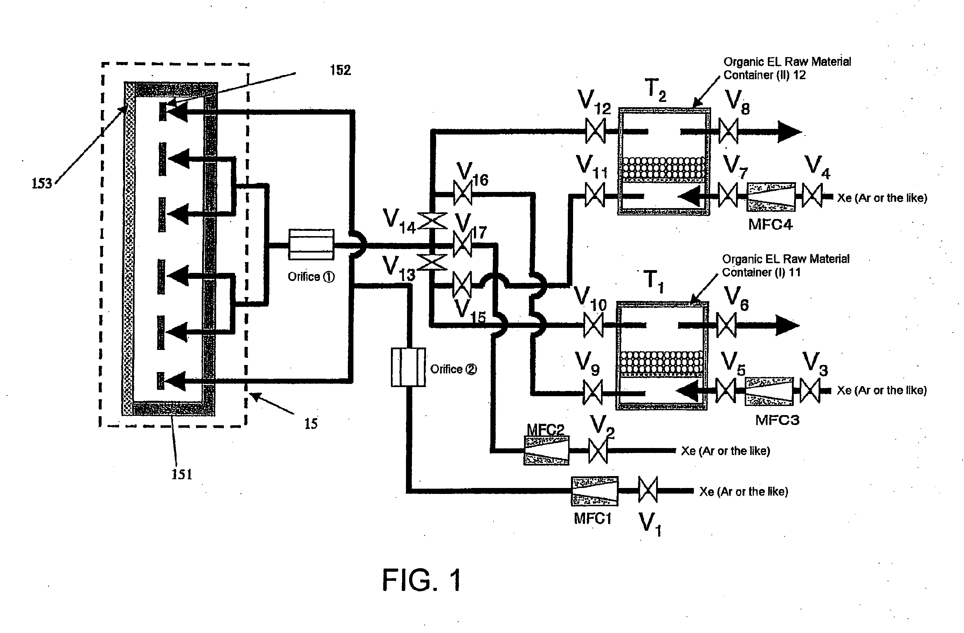

Referring to Fig. 1, a film forming apparatus according to one embodiment of this invention is shown, wherein there is illustrated a film forming apparatus for forming an organic EL film (e.g. Alq3(8-hydroxyquinoline aluminum) being a light emitting layer, NPD(C₄₄H₃₂N₂)) being a hole transport layer, or the like). The illustrated film forming apparatus is an apparatus for forming a single organic EL film and comprises two organic EL raw material containers (I) 11 and (II) 12 and an ejection vessel 15 for ejecting organic EL molecules onto a substrate of glass or the like (not shown). The two organic EL raw material containers 11 and 12 and the ejection vessel 15 are connected to each other by a piping system (i.e. flow paths) according to this invention. In the case of forming a plurality of organic EL films, the same structure is provided for a raw material of each organic EL film.

An organic compound molecule ejection apparatus 151 is disposed in the ejection vessel 15. The organic compound molecule ejection apparatus 151 comprises a plurality of gas dispersion plates (herein, six gas dispersion plates) 152 and a filter 153 made of ceramic, metal, or the like and opposed to the substrate. In this connection, the ejection vessel 15 may also be called a gas ejection portion. The substrate such as the glass substrate is held by a substrate holding portion (not shown) so as to face the organic compound molecule ejection apparatus 151. The substrate is maintained at a temperature lower than a temperature at which the raw material of an organic EL film is evaporated. On the other hand, predetermined portions of the piping system and the ejection vessel 15 are maintained at temperatures higher than the temperature at which the raw material of the organic EL film is evaporated. In this connection, the substrate holding portion, the piping system, and the ejection vessel 15 are provided with temperature controllers (not shown) for controlling them at the predetermined temperatures, respectively.

On the other hand, the two organic EL raw material containers 11 and 12 are each provided with an evaporating dish and a heater for evaporating an organic EL material. The illustrated two organic EL raw material containers 11 and 12 hold the same organic EL raw material, each thus having a function as a raw material holding portion and each further having a function as an evaporator for evaporating the organic EL material in the container 11, 12. What is shown as "Orifice" in the figure is a gas pressure control portion having an orifice and a valve for adjusting/controlling a gas pressure.

Further, the illustrated piping system comprises a carrier gas piping system for introducing a carrier gas such as xenon (Xe), argon (Ar), or krypton (Kr) into the ejection vessel 15 and an organic EL molecular gas piping system connecting the organic EL raw material containers 11 and 12 and the ejection vessel 15 to each other. The organic EL raw material containers 11 and 12 are also each provided with piping for introducing and exhausting the carrier gas. Herein, the organic EL molecular gas piping system forms a first path for the carrier gas transporting the evaporated raw material.

The illustrated carrier gas piping system comprises first piping for feeding the carrier gas to the upper and lower two gas dispersion plates 152 of the ejection vessel 15 and second piping for feeding the gas to the four gas dispersion plates 152 disposed at the center of the ejection vessel 15. Herein, the first piping is connected to the two gas dispersion plates 152 through a valve V1, a mass flow controller (MFC 1), and an orifice 2, while, the second piping is connected to the four gas dispersion plates 152 through a valve V2, an MFC 2, a valve V17, and an orifice 1. Thus, the carrier gas piping system has a plurality of second paths specified by the first piping and the second piping mentioned above.

On the other hand, upstream of the organic EL raw material container 11, the piping for introducing the carrier gas is provided and this piping has two valves V3 and V5 and an MFC 3 provided between these two valves V3 and V5, while, the piping having a valve V6 is provided as piping for exhausting the carrier gas.

Further, downstream of the organic EL raw material container 11, there is provided a piping system connected to the orifice 1 through valves V9, V16, and V14 and there is further provided a piping system connected to the orifice 1 through valves V10 and V13. These valves, the orifice 1, and the MFC 3 constitute first gas supply means reaching the ejection vessel 15 from the organic EL raw material container 11.

Likewise, upstream of the organic EL raw material container 12, the piping for introducing the carrier gas is provided and this piping has two valves V4 and V7 and an MFC 4 provided between these two valves V3 and V5, while, the piping having a valve V8 is provided as piping for exhausting the carrier gas.

Further, downstream of the organic EL raw material container 12, there is provided a piping system connected to the orifice 1 through valves V11, V15, and V13 and there is further provided a piping system connected to the orifice 1 through valves V12 and V14. These constitute second gas supply means for connecting between the ejection vessel 15 and the organic EL raw material container 12.

In the illustrated piping system, the piping systems (V9, V16, V14 and V11, V15, V13) reach the orifice 1 from the organic EL raw material containers 11 and 12, respectively, and have lengths equal to each other and, further, the lengths of the piping from the orifice 1 to the respective four gas dispersion plates 152 each forming a supply port are also equal to each other. In other words, by providing 2n (n is a positive integer) supply ports that serve to supply an organic EL molecular gas, the lengths of the piping reaching these supply ports from the orifice 1, respectively, can be made equal to each other. That is, the piping systems reaching the supply ports from the organic EL raw material containers 11 and 12, respectively, are arranged symmetrical to each other and, as a result of this, have lengths equal to each other. This also applies to the piping system connected to the orifice 1 from the organic EL raw material container 11 through the valves V10 and V13 and the piping system connected to the orifice 1 from the organic EL raw material container 12 through the valves V12 and V14.

The gas supply system constituted by the foregoing piping system is maintained at a pressure approximate to an atmospheric pressure, while, the inside of the ejection vessel 15 is maintained at a pressure of 1 Torr to several tens of Torr. For maintaining a pressure differential therebetween, the orifices 1 and 2 are provided in the illustrated example. The flow rates of the carrier gas are determined by the MFCs 1 to 4 and, further, since the number of the gas supply ports in the organic EL molecule ejection vessel 15 is set to 2n, the lengths of the piping from the pressure adjusting orifice 1 to the respective gas supply ports can be made equal to each other. In any event, by providing the foregoing piping system, it is possible to cause the gas to simultaneously reach the respective gas supply ports at the same pressure.

In the example shown in Fig. 1, of the two organic EL raw material containers 11 and 12 provided, the raw material container 11 is supplying organic EL molecules at a temperature T₁, while, the raw material container 12 is raised to a temperature (T₂) at which organic EL molecules never evaporate, thereby carrying out cleaning purge for removing surface-adsorbed impurities (e.g. moisture or organic impurities). In this case, the temperature of the piping system from the organic EL raw material container 11 to the ejection vessel 15 is maintained at a temperature higher than the temperature (T1) of the raw material container (e.g. 11) supplying the organic EL molecules so that the organic EL molecules are not adsorbed on the inner walls of the piping system.

For example, in the case where the organic EL raw material is Alq3, the temperature T1 is about 270°C, the temperature of the ejection vessel 15 is about 300°C, and the temperature of the piping system is maintained at 270°C to 300°C, while, the temperature (T₂) of the raw material container 12 which is not supplying the raw material is maintained at 100 to 220°C.

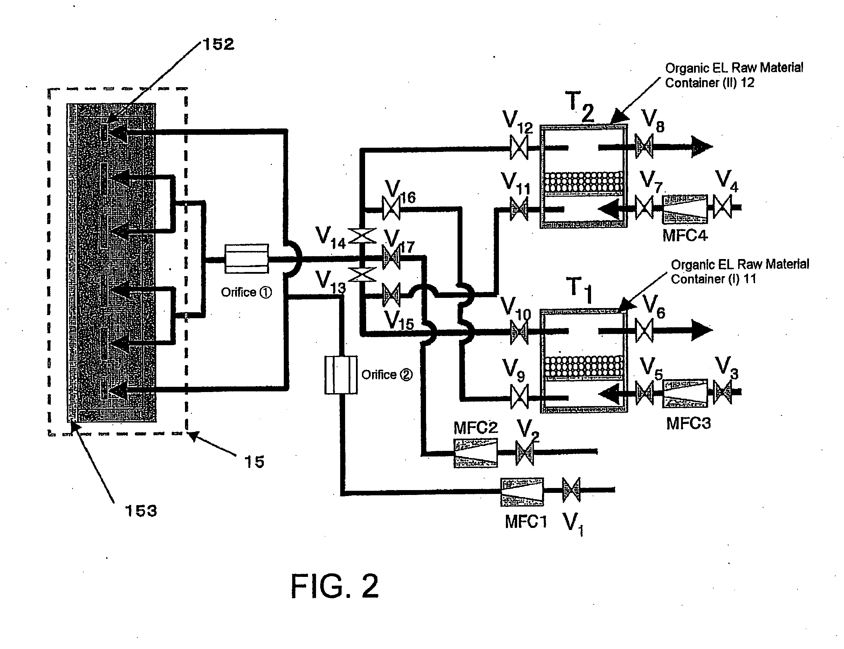

Hereinbelow, referring also to Figs. 2 to 4, the operation sequence of the film forming apparatus shown in Fig. 1 will be described. Herein, the description will be given assuming that operation modes before the start of film formation, during the film formation, and at the time of stopping the film formation are a mode 1, a mode 2, and a mode 3, respectively.

Referring to Fig. 2, the state of the mode 1 before the start of the film formation is characterized by open and closed states of the valves V1 to V17. In Fig. 2, it is assumed that the gray-colored valves are in the open state and the non-colored valves are in the closed state. Specifically, in the mode 1 shown in Fig. 2, the valves V1, V2, V3, V5, V8, V10, V11, V15, and V17 are in the open state, while, the valves V4, V6, V7, V9, V12, V13, V14, and V16 are in the closed state. Accordingly, in the mode 1, only the carrier gas such as Xe, Kr, Ar, or N2 flows into the ejection vessel 15 through the valve V1, the MFC 1, and the orifice 2 and through the valve 2, the MFC 2, the valve V17, and the orifice 1. Thus, the pressure in the ejection vessel 15 and the pressure on the substrate are controlled at predetermined values. In this case, for example, the pressure in the ejection vessel 15 may be controlled at 10Torr and the pressure on the substrate may be controlled at 1mTorr. In the state of the mode 1, since the valves V3, V5, V10, V15, V11, and V8 are in the open state, the carrier gas introduced into the organic EL raw material container 11 on the supply side of organic EL molecules is conducted or introduced to the organic EL raw material container 12 through the path of V3, the MFC 3, V5, V10, V15, and V11 and then exhausted through the valve V8. In this manner, in the state before the start of the film formation, the carrier gas is fed from the one raw material container 11 to the other raw material container 12, so that both raw material containers 11 and 12 are kept at the same temperature.

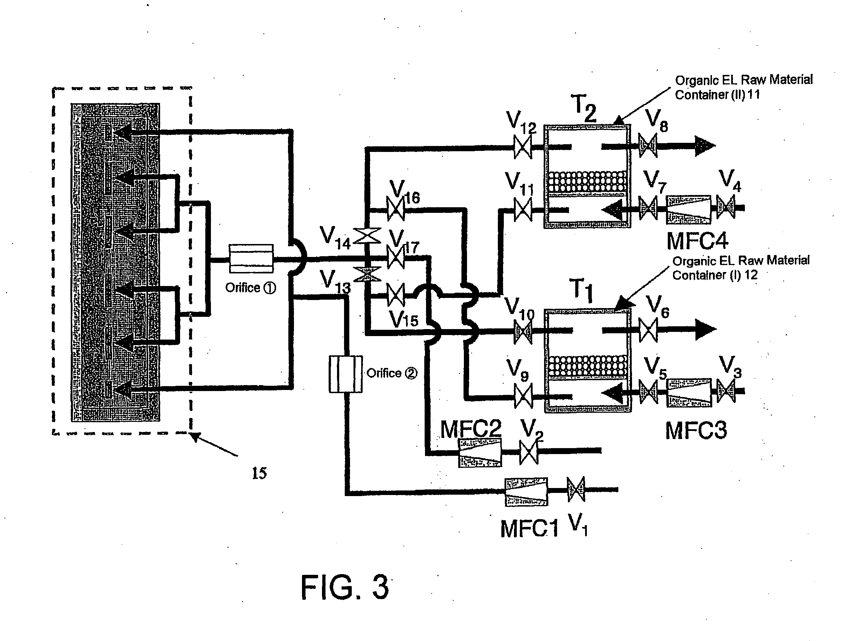

Referring to Fig. 3, there is shown the state of the mode II during the film formation. As shown in Fig. 3, in the mode II, the valves V1, V3, V4, V5, V7, V8, V10, and V13 are put into the open state, while, the valves V2, V6, V9, V11, V12, V14, V15, V16, and V17 are put into the closed state. As a result of this, the carrier gas is fed to the upper and lower supply ports of the ejection vessel 15 through V1, the MFC 1, and the orifice 2 and, further, an organic EL molecular gas evaporated in the raw material container 11 is conveyed by the carrier gas introduced through the path of the valve V3, the MFC 3, and the valve V5 and is supplied into the ejection vessel 15 through the path of V10, V13, and the orifice 1.

In this mode 2, the carrier gas (flow rate f₁) that was fed through the valve V2, the MFC 2, V17, and the orifice 1 is stopped. On the other hand, in order to keep the pressure in the ejection vessel 15 and the pressure in a chamber constant, it is preferable that the carrier gas flow rate from the raw material container 11 serving to supply organic EL molecules to the ejection vessel 15 be, in principle, set equal to the foregoing flow rate f₁. That is, the carrier gas flow rate in the path of V10, V13, and the orifice 1 is preferably equal to the flow rate f1 of the carrier gas that was fed in the path of V2, the MFC 2, V17, and the orifice 1 in the mode 1.

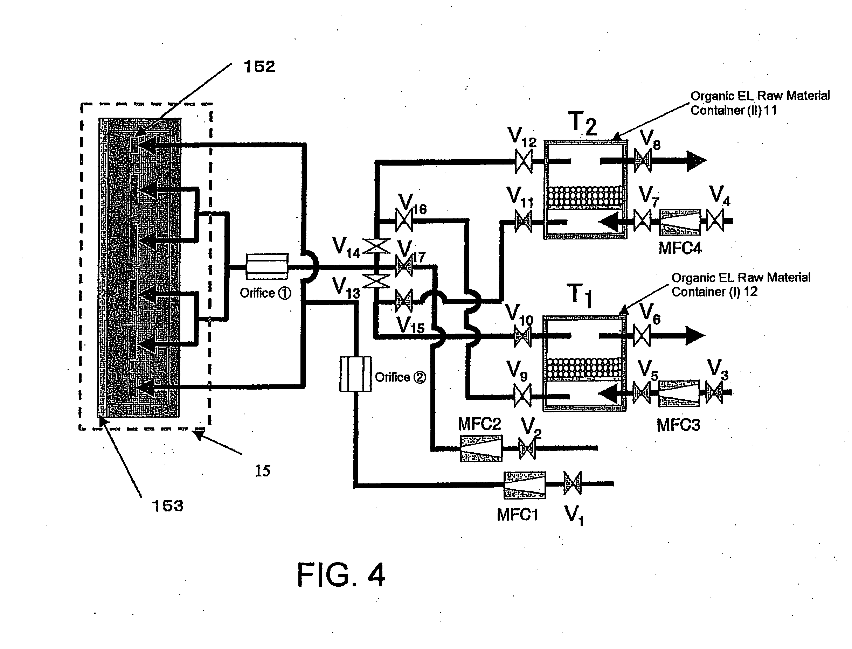

Referring to Fig. 4, the mode III operated at the time of stopping the film formation will be described. On transition from the state of the mode II to the state of the mode III, V13 is closed and V15 is opened and, simultaneously, V2 and V17 are opened. That is, in the mode III, the valves V1, V2, V3, V5, V8, V10, V11, V15, and V17 are put into the open state, while, the valves V4, V6, V7, V9, V12, V13, V14, and V16 are put into the closed state, which is the same as the state of the mode I.

In the mode III, since V13 is put into the open state while V15 is put into the closed state, the carrier gas containing organic EL molecules flows from the raw material container 11 side to the raw material container 12 at the flow rate f1 in the mode II. On the other hand, since the valves V2 and V17 are set to the open state, the carrier gas flows into the ejection vessel 15 through the orifice 1 at the flow rate f1 equal to that in the mode I. By this carrier gas, organic EL molecules in the piping from the valve V13, which was in the open state in the mode II, and the valve V14 to the ejection vessel 15 and organic EL molecules in the piping from the valve V17 to the ejection vessel 15 are blown off. Therefore, the expelling of the organic EL molecules is extremely fast at the time of stopping the film formation. The valves V13 and V15 operate as a control portion for discharging the gas containing the organic EL molecules.

As described above, the film forming apparatus according to this invention operates with the operation sequence of the modes I to III. The foregoing operation sequence has been described in the case of supplying organic EL molecules from the raw material container 11, while, in the case of feeding organic EL molecules from the raw material container 12, the operation exactly symmetric to the foregoing operation is carried out to thereby perform the same processing. In this case, since the piping system shown in Figs. 1 to 4 has the structure that is totally symmetric with respect to the raw material containers 11 and 12, even in the case of supplying organic EL molecules from the raw material container 12, exactly the same operation is carried out as that in the case of supplying organic EL molecules from the raw material container 11.

In the illustrated example, at the time of switching to the non-film-forming state, the carrier gas containing organic EL molecules is caused to flow from the one (at the temperature where the raw material is evaporated) of the raw material containers to the other (at the temperature where the raw material is not evaporated) thereof and used for separating and discharging moisture and so on of the raw material in the other and then is exhausted to an exhaust system (gas recovery system or the like), but it may be directly exhausted to the exterior (gas recovery system or the like).

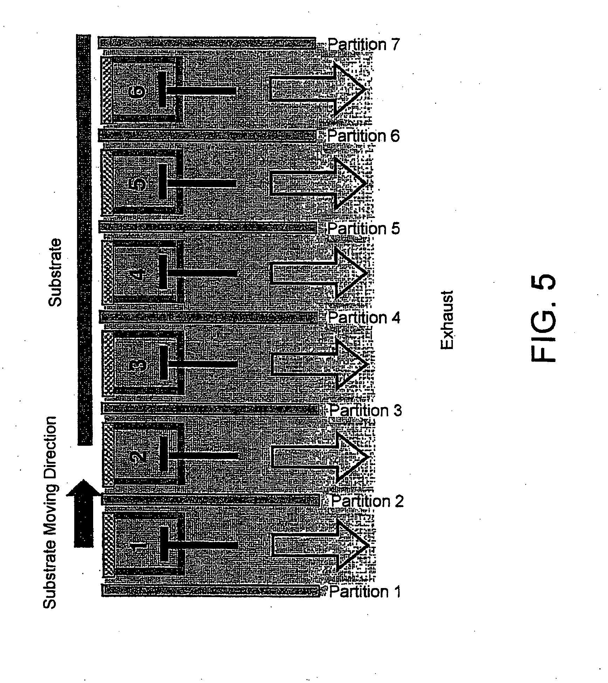

Referring to Fig. 5, a film forming apparatus according to another embodiment of this invention will be described. In Fig. 5, there is shown a film forming apparatus for use in manufacturing an organic EL device by forming organic EL films in order on a substrate of glass or the like, wherein the films of six layers are formed in order on the substrate. In this case, use can be made of a substrate having a size of 730x920 (mm) to 3000×5000 (mm). The illustrated film forming apparatus has six ejection vessels defined by partitions 1 to 7, wherein a substrate moves over the six ejection vessels from left to right in the figure and an organic EL film is formed over each of the ejection vessels. A piping system like that shown in Figs. 1 to 4 is connected to each ejection vessel. Specifically, the width of the ejection vessel in the moving direction is 100mm, the partition pitch is 200mm, the distance between the ejection vessel and the substrate is 20mm, the distance between the partition and the substrate is 2mm, the pressure in a chamber is 1mTorr, and the total length of a film forming portion is 1,200mm.

All the ejection vessels have exactly the same structure, the same piping system is connected to each of them, and the flow rates of carriers are set equal to each other. It is preferable that the temperatures of the respective ejection vessels be set according to individual properties of organic EL molecules. Further, the ejection vessels are preferably made of stainless, and an ejection portion of each ejection vessel is in the form of a stainless filter and is welded to the body. All the inner surfaces of the ejection vessels may be treated with Al₂O₃.

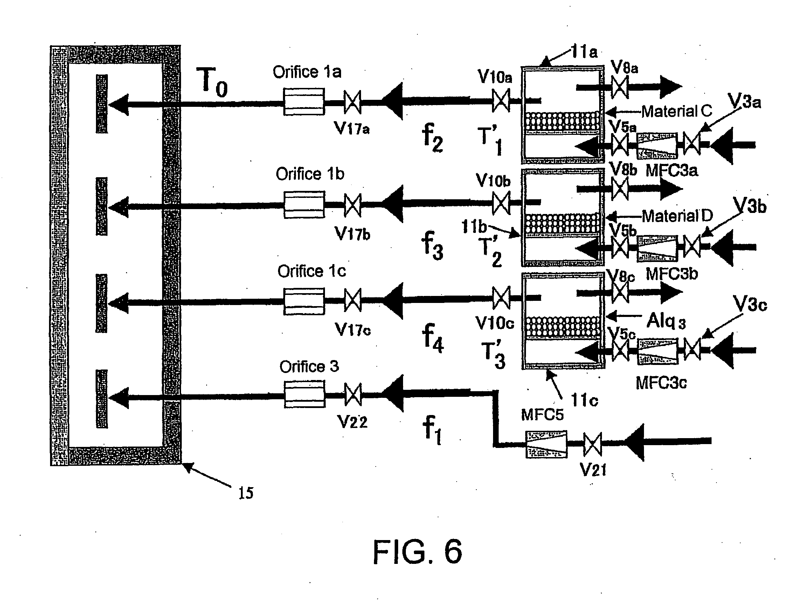

Referring to Fig. 6, the structure of a film forming apparatus according to another embodiment of this invention will be described. In this embodiment, there is shown the structure in the case of simultaneously forming, into a film, three components (material C, material D, and Alq3 material) for use in forming an organic EL device. For this, the illustrated film forming apparatus comprises material C containers 11 a, material D containers 11b, Alq3 material containers 11c, and a single ejection vessel 15. There are provided the plurality of material containers 11a, the plurality of material containers 11b, and the plurality of material containers 11 c, wherein the material containers 11 a to 11c and the ejection vessel 15 are connected by piping systems (illustration omitted), shown in Figs. 1 to 4, respectively. That is, in Fig. 6, the piping system of the material containers 11a is characterized by a valve V3a, an MFC 3a, a valve V5a, valves V10a and 17a, and an orifice 1a, likewise, the piping system of the material containers 11b is characterized by a valve V3b, an MFC 3b, a valve V5b, valves V10b and 17b, and an orifice 1b, and further, the piping system of the material containers 11c is characterized by a valve V3c, an MFC 3c, a valve V5c, valves V10c and 17c, and an orifice 1c. In the illustrated example, there is provided a piping system for feeding a mixing promotion gas, which is constituted by a valve V21, an MFC 5, a valve V22, and an orifice 3.

Since the piping systems of the material containers 11 a to 11 c are respectively controlled in the manner as described with reference to Figs. 1 to 4, the carrier gas is supplied and exhausted at the same flow rate during film formation and during non-film-formation. Herein, assuming that the flow rate of the mixing promotion gas is f1 and the flow rates of C, D, and Alq3 organic EL molecule supply gases are f2, f3, and f4, respectively, a gas ejection rate f0 from the ejection vessel 15 is given by f1+f2+f3+f4. When the ejection temperature is set to 300°C, f0 is preferably about 150cc/min. In this case, f1 is preferably about 50cc/min. Accordingly, f2+f3+f4 becomes about 100cc/min, wherein it is preferable to set them so that there is none with an excessively small flow rate. Specifically, the range of 100cc/min > f2, f3, f4 > 1cc/min is preferable. The concentrations of the respective components of an organic EL film can be adjusted by controlling the gas flow rates f2, f3, and f4 and temperatures T1' to T3' of the material containers 11a to 11c.

When a temperature T0 of the ejection vessel 15 is set to 300°C, the temperatures T1' to T3' of the material containers 11a to 11c are set to, for example, 200°C, 210°C, and 270°C and the temperatures of the piping systems between the respective material containers 11 a to 11c and the ejection vessel 15 are set to values between T0 and T1', between T0 and T2', and between T0 and T3', respectively. This makes it possible to prevent adsorption of organic EL molecules on the surfaces of the piping systems. It is preferable to select a filter so that the gas pressure in the ejection vessel 15 takes a value where the raw material gases are sufficiently mixed in the viscous flow region (e.g. a pressure of several Torr to several tens of Torr). Industrial Applicability

This invention is applicable to organic EL film formation to thereby obtain a high-quality organic EL device. Further, this invention is not only applicable to the film formation for organic EL, but also applicable to film formation for various display devices and so on that are each required to have a high quality and a long lifetime.

## Claims

1. A film forming apparatus for depositing a film of a predetermined material on a substrate by evaporateing a raw material of the predetermined material and by transporting the evaporated raw material by the use of a carrier gas, comprising:
a plurality of evaporators for evaporating the same raw material;
a first path for said carrier gas transporting the evaporated raw material to flow between said plurality of evaporators; and
a plurality of second paths for said carrier gas transporting the evaporated raw material to flow between said evaporators and an area neighboring said substrate.

2. A film forming apparatus according to claim 1, further comprising:
a substrate holding portion for holding said substrate; and
a gas ejection portion disposed so as to face the substrate to be held by said substrate holding portion and adapted to eject said carrier gas transporting the evaporated raw material and supplied through said second paths;
wherein the substrate held by said substrate holding portion is kept at a temperature lower than a temperature at which said raw material is evaporated and a predetermined portion of said first and second paths and said gas ejection portion are kept at a temperature exceeding the temperature at which said raw material is evaporated.

3. A film forming apparatus according to claim 2, further comprising:
gas supply mechanism for supplying a second gas of the substantially same kind as said carrier gas to said gas ejection portion without allowing said second gas to pass through said evaporators.

4. A film forming apparatus according to claim 3, wherein said gas supply mechanism comprises a first gas supply mechanism for supplying said second gas to said gas ejection portion using said second paths and a second gas supply mechanism for supplying said second gas to said gas ejection portion through a third path provided independently of said second paths.

5. A film forming apparatus according to claim 1, wherein:
said first path is partly overlapped with said second paths.

6. A film forming apparatus according to claim 1, wherein:
said carrier gas transporting said evaporated raw material is caused to flow from at least one of said plurality of evaporators into at least one of the remainder of said plurality of evaporators through said first path at a timing before film formation and/or a timing when the film formation is stopped.

7. A film forming apparatus according to claim 3, wherein:
said second gas is supplied to said gas ejection portion before film formation and at the time when the film formation is stopped.

8. A film forming apparatus according to claim 1, wherein said carrier gas transporting said evaporated raw material is supplied to said gas ejection portion from at least one of said plurality of evaporators during film formation using at least one of said second paths.

9. A film forming apparatus according to claim 4, wherein, before film formation and when the film formation is stopped, said carrier gas transporting said evaporated raw material is caused to flow from at least one of said plurality of evaporators into at least one of the remainder of said plurality of evaporators through said first path and said second gas is supplied to said gas ejection portion from said first and second gas supply mechanisms; and wherein, during the film formation, said carrier gas transporting said evaporated raw material is supplied to said gas ejection portion from at least one of said plurality of evaporators through at least one of said second paths and said second gas is supplied to said gas ejection portion through said third path.

10. A film forming apparatus according to claim 1, wherein each of said evaporators has a first inlet for supplying the carrier gas, a second inlet for supplying the carrier gas from one of the other evaporators, a first outlet for outputting the carrier gas transporting the evaporated raw material, and a second outlet for outputting the carrier gas to a recovery system.

11. A film forming apparatus according to claim 10, wherein each of said evaporators further comprises a raw material holding portion provided between said first and second inlets and said first and second outlets and holding said raw material so as to enable said carrier gas to pass therethrough.

12. A film forming apparatus according to claim 8, wherein said at least one of said evaporators is heated to a temperature at which said raw material is evaporated and at least one of the remainder of said evaporators is maintained at a temperature at which said raw material is not evaporated.

13. A film forming apparatus according to claim 1, wherein said carrier gas contains an inert gas as a main component.

14. A film forming apparatus according to claim 1, wherein said carrier gas contains at least one of nitrogen, Xe, Kr, Ar, Ne, and He.

15. A film forming apparatus according to claim 1, wherein said predetermined material is an organic EL element material.

16. A film forming method of depositing a film of a predetermined material on a substrate, by evaporating a raw material for use in forming the film of the predetermined material and by transporting the evaporated raw material to a gas ejection portion using a carrier gas, wherein the carrier gas is caused to flow into an evaporator so as to make a gas phase pressure in said evaporator substantially equal to that during film formation, at a timing before the film formation and/or at a timing when the film formation is stopped.

17. A film forming method according to claim 16, wherein said evaporator comprises first and second raw material holding portions and
wherein said method comprises a step of evaporating said raw material in said first raw material holding portion holding said raw material and a step of causing the carrier gas transporting said evaporated raw material to flow from said first raw material holding portion into said second raw material holding portion holding the same raw material as said raw material.

18. A film forming method according to claim 17, further comprising a step of supplying said carrier gas to said gas ejection portion at a timing before the film formation and/or at a timing when the film formation is stopped.

19. A film forming method according to claim 17, comprising, during the film formation, a step of evaporating said raw material in said first raw material holding portion and a step of supplying the carrier gas transporting said evaporated raw material to said gas ejection portion from said first raw material holding portion.

20. A film forming method according to claim 19, further comprising a step of supplying the carrier gas free from said raw material to said gas ejection portion during the film formation.

21. A film forming method of depositing a film of a predetermined material on a substrate, by evaporating a raw material for use in forming the film of the predetermined material and by transporting the evaporated raw material to a gas ejection portion using a carrier gas, said film forming method comprising:
a first step of evaporating said raw material in a first raw material holding portion holding said raw material in a first period of time;
a second step of discharging the carrier gas transporting said evaporated raw material from said first raw material holding portion to the outside of said first raw material holding portion in said first period of time;
a third step of supplying the carrier gas free from said raw material to said gas ejection portion in said first period of time;
a fourth step of evaporating said raw material in said first raw material holding portion in a second period of time different from said first period of time; and
a fifth step of supplying the carrier gas transporting said evaporated raw material to said gas ejection portion from said first raw material holding portion in said second period of time.

22. A film forming method according to claim 21, further comprising a sixth step of supplying the carrier gas free from said raw material to said gas ejection portion in said second period of time.

23. A film forming method according to claim 21, wherein said second step comprises a step of causing the carrier gas transporting said evaporated raw material to flow into a second raw material holding portion holding the substantially same raw material as said raw material.

24. A film forming method according to claim 23, comprising a step of maintaining said second raw material holding portion at a temperature at which said raw material is not evaporated.

25. A film forming method according to claim 16 or 21, wherein said carrier gas contains at least one of nitrogen, Xe, Kr, Ar, Ne, and He.

26. A film forming method according to claim 16 or 21, wherein said predetermined material is an organic EL element material.

27. A film forming apparatus comprising a plurality of raw material containers for evaporating a raw material for use in forming a film of a predetermined material, a piping system for transporting the evaporated raw material by the use of a carrier gas, a gas pressure control portion disposed in said piping system, an ejection vessel for depositing said film of the predetermined material on a substrate, and a plurality of gas-supply ports provided in said ejection vessel, wherein said plurality of raw material containers are controlled to selectively supply said evaporated raw material to said ejection vessel through said piping system, and wherein said piping system includes a plurality of paths between said gas pressure control portion and said plurality of gas-supply ports, lengths of said paths being equal to each other.

28. A film forming apparatus according to claim 27, wherein the number of said gas-supply ports is 2n (n is a positive integer).

29. A film forming apparatus according to claim 28, wherein said paths of said piping system between said gas pressure control portion and said supply ports in said ejection vessel has a mutually symmetrical structure.

30. A film forming apparatus according to claim 29, wherein said piping system includes a plurality of paths for a gas containing no raw material.
